Europäisches Patentamt

European Patent Office

Office européen des brevets

(11) Publication number: **0 237 041 B1**

(12) **EUROPEAN PATENT SPECIFICATION**

(45) Date of publication of patent specification: **18.08.93**    (51) Int. Cl.⁵: **G02B  17/08**

(21) Application number: **87103472.4**

(22) Date of filing: **11.03.87**

(54) **Projection optical system for use in precise copy.**

(30) Priority: **12.03.86 JP 54051/86**
**07.07.86 JP 159055/86**

(43) Date of publication of application:
**16.09.87 Bulletin  87/38**

(45) Publication of the grant of the patent:
**18.08.93 Bulletin  93/33**

(84) Designated Contracting States:
**DE FR GB**

(56) References cited:
**FR-A- 784 063**
**GB-A- 548 729**
**US-A- 3 325 238**

**APPLIED OPTICS, vol. 14, no. 9, September 1975, pages 2302-2305; R.D.SIGLER: "Compound Schmidt telescope designs with nonzero Petzval curvatures"**

(73) Proprietor: **MATSUSHITA ELECTRIC INDUSTRI-AL CO., LTD.**
**1006, Oaza Kadoma**
**Kadoma-shi, Osaka-fu, 571(JP)**

(72) Inventor: **Satoh, Takeo**
**10-20-102, Sagamiono-5-chome**
**Sagamihara-shi(JP)**
Inventor: **Araki, Nobuhiro**
**111, Kamisugetacho**
**Hodogaya-ku Yokohama(JP)**
Inventor: **Kawata, Koichi**
**6-18, Nagayama-6-chome**
**Tama-shi(JP)**
Inventor: **Nomura, Noboru**
**35, Fukakusa-Nakanoshimacho**
**Fushimi-ku Kyoto(JP)**
Inventor: **Ueno, Atushi**
**52-9, Nagaomotomachi-7-chome**
**Hirakata-shi(JP)**
Inventor: **Yoshida, Shotaro**
**10-23, Kamisugi-1-chome**
**Sendai-shi(JP)**

(74) Representative: **Patentanwälte Leinweber & Zimmermann**
**Rosental 7/II Aufg.**
**D-80331 München (DE)**

**Description**

BACKGROUND OF THE INVENTION

The present invention relates to a projection optical system for use in a precise copy which is suitable for use in the case of ultrashort wavelengths such as ultraviolet rays, far ultraviolet rays, and the like.

Hitherto, a projection optical system for use in a precise copy which consists of a refractive system using lenses has been known as shown in, e.g., Japanese patent publication (JP-B) No. 12966/82. Another projection optical system consisting of a reflecting system has also been known as shown in Japanese laid-open patent publication (JP-A) No. 17196/80.

The conventional projection optical systems for use in a precise copy will be described hereinbelow with reference to the drawings.

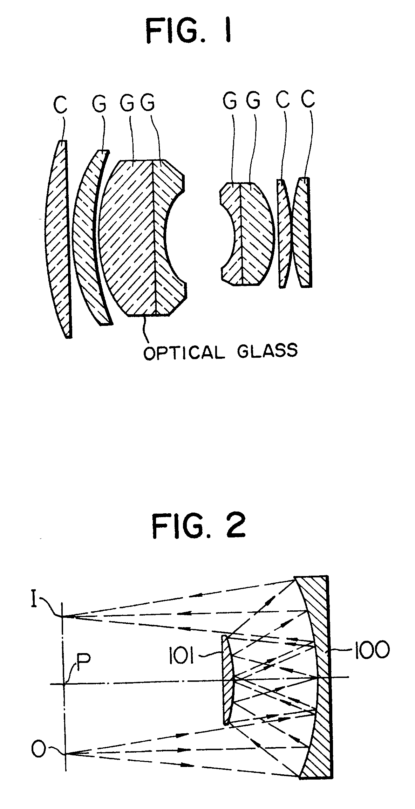

As shown in Fig. 1, the optical system consisting of the refracting system uses a plurality of lenses consisting of optical glasses G and optical crystal materials C and is the reducing system having an image magnification of 1/10. On the other hand, as shown in Fig. 2, the projection optical system using the reflecting system has a telecentric constitution such that the lights emitted from an object O are sequentially reflected by a main mirror 100, an auxiliary mirror 101, and the main mirror 100, thereby forming an image I of the equal magnification of 1/1 onto the same plane as the object O.

A resolution limit D of the projection optical system is expressed using an equation of Rayleigh as follows.

$$D = 0.61 \frac{\lambda}{NA}$$

where, NA is a numerical aperture on the side of the image of the optical system and $\lambda$ is a wavelength which is used. In order to improve the resolving power, it is sufficient to reduce the use wavelength $\lambda$ or to increase the numerical aperture NA of the optical system. However, the improvement of the numerical aperture NA makes the optical design of the lenses remarkably difficult. Therefore, the reduction of the use wavelength $\lambda$ is becoming the main current.

In the conventional refracting optical system shown in Fig. 1, when the use wavelength $\lambda$ is reduced to a value in the range of the ultraviolet rays, the transmittance extremely decreases. For example, even if the glasses whose characteristics were adjusted for use in the wavelengths in the range of, particularly, the ultraviolet rays, such as glasses of UBK7 made by Schott, Co., Ltd. are used, when the wavelength is 280 nm, the transmittance extremely decreases to 23% (when the thickness of glass is 5 mm). On the other hand, among the optical crystal materials C, there are such materials that the transmittance of about 80% can be obtained even in the case of the wavelength of about 200 nm as in the synthetic crystal of $TiF_2$, $CaF_2$, or $KC\ell$. However, in general, it is difficult to obtain a large sized crystal material and the working efficiency is very bad and it is difficult to work with a high precision. In addition, since the number of kinds of such crystal materials is limited, the degree of freedom in designing is small. There is the case of realizing a rediffraction optical system having a large numerical aperture NA with a high transmittance held by use of the limited number of lenses in the case of the wavelength in the range of the ultraviolet rays or of the far ultraviolet rays. In this case, the aberration cannot be sufficiently corrected and it is difficult to constitute the optical system by only the refracting materials.

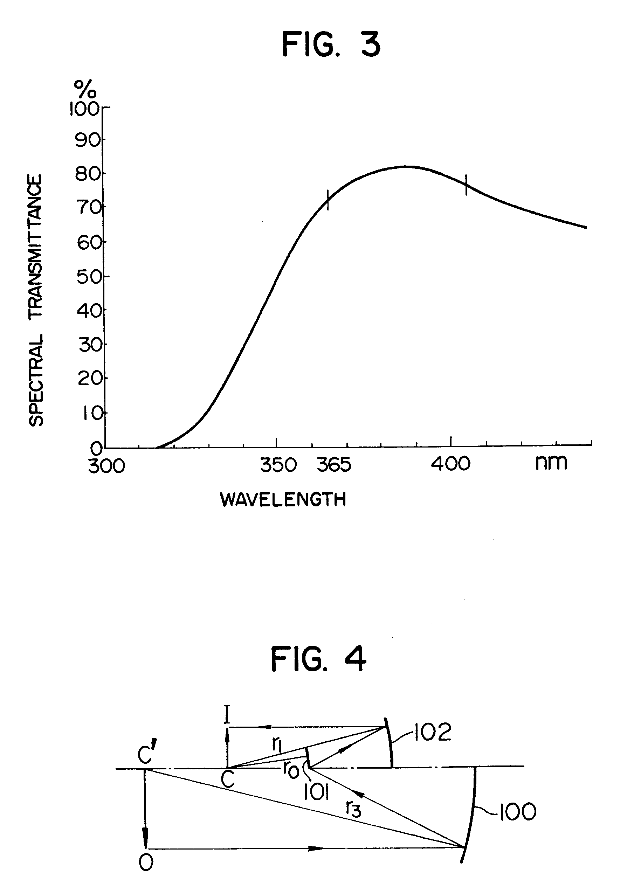

Fig. 3 is a graph showing the spectral transmittance of the reducing projection optical system shown in Fig. 1. As will be obvious from this graph, when the use wavelength is below 300 nm, the transmittance is almost 0 and the wavelength in the range of the ultraviolet rays cannot be used.

On the other hand, since the example of Fig. 2 is constituted by only the reflecting mirrors, the use wavelength is not limited. However, since the main mirror 100 and auxiliary mirror 101 are coaxially arranged with respect to a point P on the axis of the object O and image I, the spherical aberration, coma aberration, and distortion aberration are preferably corrected. However, since the astigmatism in the tangential direction is large, the image plane is curved. To avoid this problem, a slit is used and an arc-shaped field is formed at such an image height that the astigmatisms in the tangential and sagittal directions coincide and the astigmatic difference becomes 0. For example, in the case of exposing a mask pattern onto a semiconductor wafer, a necessary projection field is obtained by simultaneously scanning the mask as an object O and a wafer as an image plane I, thereby realizing the optical system near the zero aberration. However, when the reflecting optical system is constituted as a reducing optical system, it

2

EP 0 237 041 B1

becomes as shown in Fig. 4. If the telecentric is held, all of the main mirror 100, a main mirror 102, and the auxiliary mirror 101 are not coaxially arranged. Namely, when the main mirror 102 and auxiliary mirror 101 are coaxially arranged around the point C, the center of the main mirror 100 is deviated to C', so that the outer axial aberration deteriorates. Further, since the object O and image I are not located on the same plane, it is necessary to individually scan the mask and wafer and to change the scanning speed in accordance with only the ratio of the image magnification. Since the error of the scanning speed results in the distortion of the image upon projection, it is necessary to accurately control the scanning speed. However, as the projected image becomes fine, it becomes fairly difficult to accurately control the scanning speed. Thus, in realizing of the reducing optical system using the reflecting optical system is shown in Fig. 4, there are problems of the correction of the optical aberration and the mechanism.

In GB-A-548 729 is described an optical objective for photographic or other purposes which is intended for equal scale copying and consists of a symmetrical arrangement of two catadioptric optical systems, each including a concave mirror member having an opening in its center and a convex mirror member, and between the two catadioptric optical systems two refracting correction members. The light of an object point enters into the opening in the concave mirror member of the first optical system and passes after reflection in turn at the convex mirror member and the concave mirror member through the refracting correction members and is then reflected in turn at the concave mirror member and the convex mirror member of the second optical system for leaving the system through the opening of the concave mirror member of the second optical system.

Further, from US-A-3 325 238 is known a solar simulator which is intended for obtaining parallel radiant energy rays from a radiant energy source. The solar simulator consists of a number of lenses and annular convex and concave mirror members which are arranged concentrical with reference to the optical axis of the system. The convex and concave mirror members are forming two catadioptric optical systems, each consisting of a concave mirror member having a central opening and a convex mirror member having a central opening. For achieving a more uniform illumination intensity, the two catadioptric optical systems are such arranged that a first system collimates the rays in an outer zone to form an annular outer illuminating zone, but passes the rays of an inner zone, whereas the second optical system collimates an outer portion of the rays in the inner zone to form an annular intermediate illuminating zone which is contiguous with the outer illuminating zone, and additionally includes a central refractive collimating system for collimating the remaining inner portion of the rays in the inner zone to form an inner illuminating zone.

However, in this known system the rays merely are passing either the one or the other of the two catadioptric optical systems or even the central refractive collimating system, but they are not reflected from the one catadioptric optical system to the other catadioptric optical system, nor is the known system intended to project an optical image.

Finally, Applied Optics, Vol. 14, No. 9, September 1975, pages 2302 to 2305, R. D. Sigler, "Compound Schmidt telescope designs with nonzero Petzval curvatures" describres the theory of high performance photo/visual instruments consisting of catadioptric optical systems, which are commonly known as Schmidt telescope configurations. However, there are not described any systems combining two catadioptric optical systems as it is necessary for the projection of an optical image in the narrow field.

## SUMMARY OF THE INVENTION

It is an object of the present invention to solve the foregoing problems and to provide a projection optical system for use in a precise copy in which an amount of absorbed lights is reduced as small as possible, high transmittances in the ranges of the ultraviolet rays are derived, and a small optical aberration and a high resolving power are obtained.

Another object of the invention is to provide a projection optical system for use in a precise copy in which even under the coherent illumination, the loss due to the reflecting mirror is eliminated, the overlaps of the zeroth-degree and ± first-degree diffracted lights are derived to thereby form an image and a fine pattern is projected.

According the the present invention, there is provided a projectional optical system for use in making a precise copy, comprising: a pair of catadioptric optical systems each including an associated refracting aspheric correction member, a convex mirror member, and a concave mirror member having an opening at the center thereof, said convex mirror member and said concave mirror member being coaxially arranged with a common curvature center located at the center of the entrance pupil, and said associated refracting aspheric correction member being substantially placed at said entrance pupil, said pair of catadioptric optical systems being arranged rotationally symmetric around a reference axis and being coaxially coupled in such a way that said associated refracting aspheric correction members face each other, one of said pair

3

of catadioptric optical systems being arranged on the side of the object to be projected, and the other catadioptric optical system being arranged on the side of the projected image, said object being placed on the focal plane of said one of said pair of catadioptric optical systems and said object being projected on the focal plane of said other of said pair of catadioptric optical systems; wherein said convex mirror members each have an opening at the center thereof, the optical system includes a coherent illuminating light source for convergently illuminating the object to be projected such that a first part of the illumination rays from said light source are focused by said one of said pair of catadioptric optical systems to the plane of the entrance pupil, and a second remaining part of the illumination rays from said light source are converged through the opening of the convex mirror member to the plane of the entrance pupil, said one of said pair of catadioptric optical systems, located on the side of the object to be projected, is arranged in a manner such that after the rays emitted from the object pass through the opening of the concave mirror member thereof, said second part of the rays pass through the opening of the convex mirror member thereof and said first part of the rays are reflected by the convex mirror member thereof to the concave mirror member thereof and are further reflected by the concave mirror member thereof, and both of said first and second parts of the rays pass through the refracting aspheric correction member thereof, and said other of said pair of catadioptric optical systems, located on the side of the projection image, is arranged in a manner such that after the incident rays passed through the refracting aspheric correction member thereof, a first part of the rays pass through the opening of the convex mirror member thereof and the opening of the concave mirror member thereof and a second remaining part of the rays are reflected by the concave mirror member thereof to the convex mirror member thereof and are further reflected by the convex mirror member thereof and pass through the opening of the concave mirror member thereof, and all of the rays are overlapped in a plane which is perpendicular to the reference axis and behind the concave mirror member thereof, so that an image is formed.

BRIEF DESCRIPTION OF THE DRAWINGS

Fig. 1 is an overall cross sectional view of a reducing projection optical system for use in a copy which uses a conventional refracting system;

Fig. 2 is a cross sectional view of a projection optical system for use in a copy which uses a conventional reflecting system;

Fig. 3 is a diagram showing the spectral transmittance of the conventional example shown in Fig. 1;

Fig. 4 is an imaginary schematic diagram in the case where the conventional example shown in Fig. 2 was modified to the reducing system;

Fig. 5 is a schematic diagram of a projection optical system for use in a precise copy similar to that which is known from GB-A- 548 729

Fig. 6 is an explanatory diagram of the operation of the constitution of Fig. 5;

Fig. 7 shows aberration characteristic diagrams based on the constitution of Fig. 5;

Fig. 8 is a cross sectional view of a refracting aspheric correction plate in a projection optical system for a precise copy as it may be used in the present invention;

Fig. 9 is a schematic diagram of a projection optical system for use in a precise copy according to the present invention;

Fig. 10 is an enlarged diagram of the main part in Fig. 9; and

Fig. 11 is an explanatory diagram showing a transmitting state of the zeroth-degree diffracted light in the constitution of Fig. 9.

DETAILED DESCRIPTION OF THE INVENTION

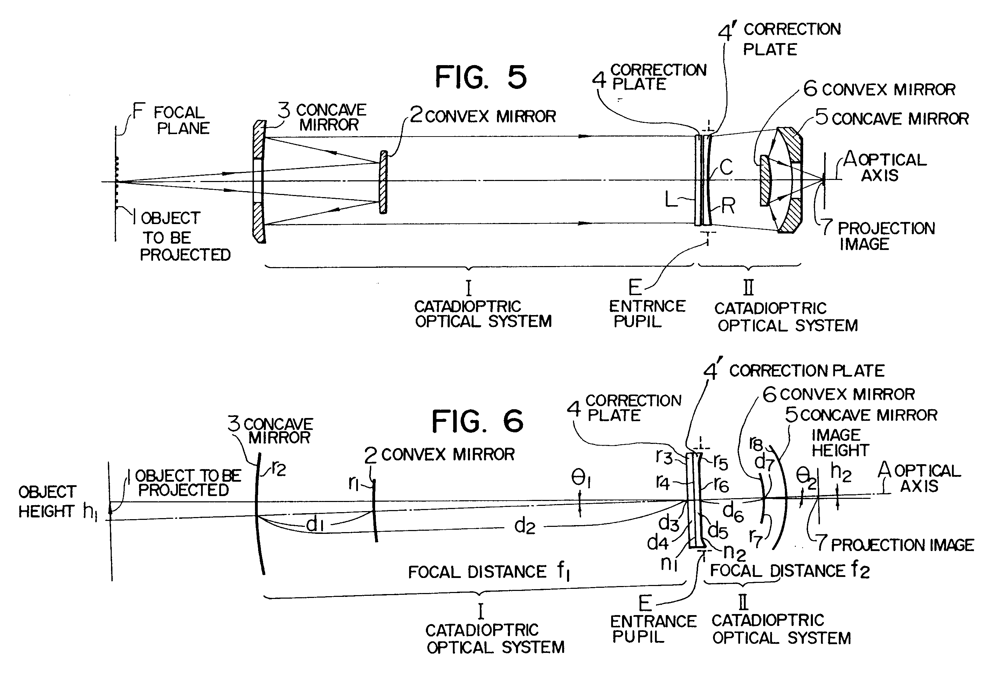

Fig. 5 is an overall cross sectional view showing a projection optical system for use in a precise copy similar to that which is known from GB-A-548 729, which is useful for the understanding of the principles on which the present invention is based.

A catadioptric optical system I on the object point side is constituted by a convex mirror 2, a concave mirror 3 having an opening at the center, and a refracting aspheric correction plate 4. An object 1 to be projected is placed on the focal plane F of the catadioptric optical system I. In the optical system I, the concave mirror 3, convex mirror 2, and correction plate 4 are arranged in accordance with this order for the object 1. A catadioptric optical system II on the image point side is constituted by a refracting aspheric correction plate 4', a concave mirror 5 having an opening at the center, and a convex mirror 6. In the optical system II, the correction plate 4', convex mirror 6, and concave mirror 5 are arranged in accordance with this order for the object 1. The catadioptric optical systems I and II are coupled in a manner such as to commonly have an entrance pupil E on the coaxis and to respectively face the correction plates 4 and 4' which are disposed at a slight distance.

The convex mirror 2 and concave mirror 3, and the convex mirror 6 and concave mirror 5 are respectively coaxially arranged around a point C, as a center, on an optical axis A of the entrance pupil E. The surface on the L (left) side of the correction plate 4, i.e., on the side of the convex mirror 2, the surface on the R (right) side of the correction plate 4', i.e., on the side of the convex mirror 6, and the concave mirrors 3 and 5 are formed as aspheric surfaces.

The lights emitted from one point of object 1 pass through the opening of the concave mirror 3 and are reflected to the side of the object 1 by the convex mirror 2. Thereafter these lights are reflected again by the concave mirror 3 and pass through the correction plate 4. The lights transmitted through the correction plate 4 become parallel light and enter the correction plate 4' disposed at a slight distance away from the correction plate 4 and are reflected to the side of the object 1 by the concave mirror 5. Then, the reflected light is again reflected by the convex mirror 6 to the side opposite to the object 1 and pass through the opening of the concave mirror 5. Thus, a projection image 7 is formed in the plane perpendicular to the reference axis and behind the concave mirror 5.

An image magnification $\beta$ in this arrangement will now be described with reference to Fig. 6. It is assumed that the height of object is $h_1$, the height of image is $h_2$, the focal distance of the catadioptric optical system I is $f_1$, the focal distance of the catadioptric optical system II is $f_2$, the angle of the object height $h_1$ to the center C of the correction plate 4 using the optical axis A as a reference is $\theta_1$, and the angle of the image height $h_2$ to the center of the phase correction plate 4' using the optical axis A as a reference is $\theta_2$. In this case, the image magnification $\beta$ is given by the following expression.

$$\beta = \frac{h_2}{h_1} \fallingdotseq \frac{f_2 \cdot \tan\theta_2}{f_1 \cdot \tan\theta_1}$$

Since the entrance pupil E is set to the top of the correction plate 4', $\theta_1 = \theta_2$ and the ratio $f_2/f_1$ of the focal distances is used as the magnification $\beta$. In other words, since the entrance pupil E is commonly used and the effective radii are equal, the ratio of the aperture ratios is set to the magnitude $\beta$.

Therefore, the aperture ratio of the whole system (which is obtained as a coupled system of the catadioptric optical systems I and II) to determine the theoretical resolution limit is decided by the optical system II on the projection image side. The aperture ratio can be increased because the whole system is independent of the aperture ratio of the optical system I on the side of an object to be projected. Therefore, the whole system can be easily designed and worked.

The light emitted from the object 1 is once converted into the parallel light by the optical system I on the object point side and the parallel light is focused by the optical system II on the image point side, thereby forming an image. Therefore, the optical system I on the object side functions as a kind of afocal converter. The incident angle of the light from the object 1 disposed at a limited distance into the optical system II on the image point side can be reduced and the amount of generation of the optical aberrations out of the axis can be reduced.

In the optical systems I and II, the concave mirrors 3 and 5 and the convex mirrors 2 and 6 are coaxially arranged around the center point of the entrance pupil E as the center C. Thus, the amount of generation of the coma aberration, astigmatism, and distortion aberration can be minimized. The batch projection optical system as in the present invention has a large spherical aberration as compared with the conventional one. However, the remaining spherical aberration can be eliminated by forming the correction plates 4 and 4' and concave mirrors 3 and 5 into aspheric surfaces as mentioned above.

The catadioptric optical system I on the side of the object to be projected and the catadioptric optical system II on the side of the projection image independently correct the spherical aberration as an aberration on the axis and the coma aberration, astigmatism, and distortion aberration as aberrations out of the axis. Therefore, even in the case where the optical systems I and II are coupled as a whole system, the optical system having a relatively low aberration is realized.

Practical particulars in this arrangement may be:

Whole system f (focal distance) : 100 mm

Effective F number (aperture ratio): 1.3

Use wavelength : 200 nm

Magnification: 1/5

| | | |
|---|---|---|
| $r_1$ = 322.342 | $d_1$ = -120.170 | Reflecting surface |
| $r_2$ = 442.512 (aspheric surface) | $d_2$ = 442.512 | Reflecting surface |
| $r_3$ = 0 (aspheric surface) | $d_3$ = 5.935 | $n_1$ = 1.560769 |
| $r_4$ = 0 | $d_4$ = 0.119 | |
| $r_5$ = 0 | $d_5$ = 5.935 | $n_2$ = 1.560769 |
| $r_6$ = 0 (aspheric surface) | $d_6$ = 88.502 | |
| $r_7$ = -88.502 (aspheric surface) | $d_7$ = -24.034 | Reflecting surface |
| $r_8$ = -64.468 | | Reflecting surface |

where, as shown in Fig. 6,

| | |
|---|---|
| $r_1$ : | radius of curvature of the reflecting surface of the convex mirror 2 |
| $r_2$ : | radius of curvature of the reflecting surface of the concave mirror 3 |
| $r_3, r_4$ : | radius of curvature of each surface of the correction plate 4 |
| $r_5, r_6$ : | radius of curvature of each surface of the correction plate 4' |
| $r_7$ : | radius of curvature of the reflecting surface of the concave mirror 5 |
| $r_8$ : | radius of curvature of the reflecting surface of the convex mirror 6 |
| $d_1$ : | distance between the reflecting surface of the convex mirror 2 and the reflecting surface of the concave mirror 3 |
| $d_2$ : | distance between the reflecting surface of the concave mirror 3 and the surface on the incident side of the correction plate 4 |
| $d_3$ : | thickness of the correction plate 4 |
| $d_4$ : | distance between the correction plates 4 and 4' |
| $d_5$ : | thickness of the correction plate 4' |
| $d_6$ : | distance between the surface on the emitting side of the correction plate 4' and the reflecting surface of the concave mirror 5 |
| $d_7$ : | distance between the reflecting surface of the concave mirror 5 and the reflecting surface of the convex mirror 6 |
| $n_1$ : | refractive index of the correction plate 4 |
| $n_2$ : | refractive index of the correction plate 4' |
| Aspheric surface coefficient: | the coefficient in the case where a sag amount Z is expressed by the following equation |

$$Z = \frac{Ch^2}{1+\sqrt{1-(K+1)C^2h^2}} + A_4h^4 + A_6h^6 + A_8h^8 + A_{10}h^{10}$$

| Surface | K | $A_4$ | $A_6$ | $A_8$ | $A_{10}$ |
|---|---|---|---|---|---|
| $r_2$ | 0 | -1.67x10$^{-11}$ | -4.08x10$^{-16}$ | -3.42x10$^{-21}$ | 3.73x10$^{-27}$ |
| $r_3$ | 0 | -2.31x10$^{-9}$ | -8.16x10$^{-15}$ | -2.51x10$^{-20}$ | 8.64x10$^{-26}$ |
| $r_6$ | 0 | -2.88x10$^{-7}$ | 2.54x10$^{-11}$ | 1.96x10$^{-15}$ | -1.69x10$^{-19}$ |
| $r_8$ | 0 | 2.08x10$^{-9}$ | 1.27x10$^{-12}$ | 2.68x10$^{-16}$ | -7.28x10$^{-21}$ |

where, $K = -e^2$, e is the eccentricity, h is the light entrance height, $A_4$, $A_6$, $A_6$, and $A_{10}$ are aspheric surface coefficients of the surfaces $r_2$, $r_3$, $r_6$, and $r_8$, respectively, $C = 1/r$, and r is the radius of curvature.

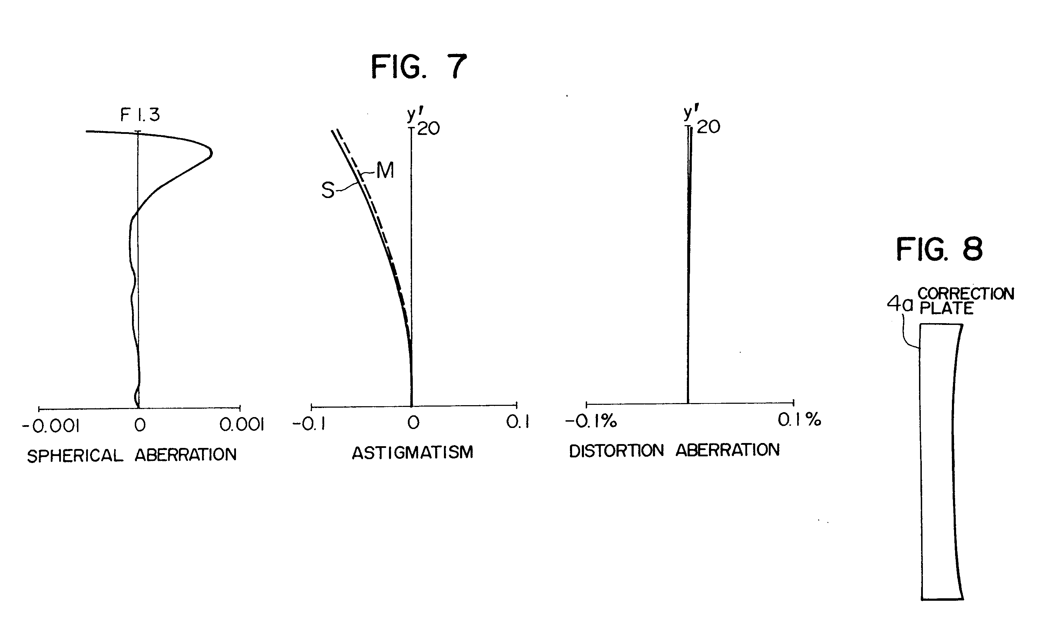

Fig. 7 shows the spherical aberration, astigmatism, and distortion aberration according to the practical particulars.

Most of the spherical aberration is eliminated by the correction plates 4 and 4' of the aspheric surfaces each of which consists of fused quartz. The remaining high-degree spherical aberration is further corrected by the concave mirrors 3 and 5.

With respect to the astigmatism, distortion aberration, and coma aberration, the concave mirrors 3 and 5 and the convex mirrors 2 and 6 are coaxially arranged with regard to the entrance pupil E, the convex mirrors 2 and 6 are formed into the spherical surfaces and are set to be concentric for the concave mirrors 3 and 5 even in the case of the light beams out of the axis, respectively, thereby fairly reducing the generation of the aberration amount. Moreover, in this arrangement, since only the fused quartz which is used to form the correction plates 4 and 4' is used as a refracting material, the transmittance above 60% is also derived in the case of the wavelength of $\lambda$ = 200 nm.

As shown in Fig. 8, two refracting aspheric correction plates 4 and 4' in the foregoing arrangement are integrally coupled in the flat surface portions or they are previously formed as an integrated plate, and two catadioptric optical systems I and II commonly use a single refracting aspheric correction member 4a.

According to the invention, two catadioptric optical systems consisting of the concave mirror members, convex mirror members, and phase correction members are coupled so as to face each other on the coaxis through the refracting aspherical correction members to thereby constitute one common catadioptric optical system. Therefore, not only the spherical aberration as an aberration on the axis but also the coma aberration, astigmatism, and distortion aberration as aberrations out of the axis can be extremely reduced and the high resolving power can be derived. Since the main refracting force is obtained by the reflecting system, only the refracting aspheric correction member is used as a refracting material. High transmittances in the ranges of the ultraviolet rays and of the far ultraviolet rays can be obtained and the projection optical system of the invention can be applied to the ranges of the ultraviolet rays and of the far ultraviolet rays.

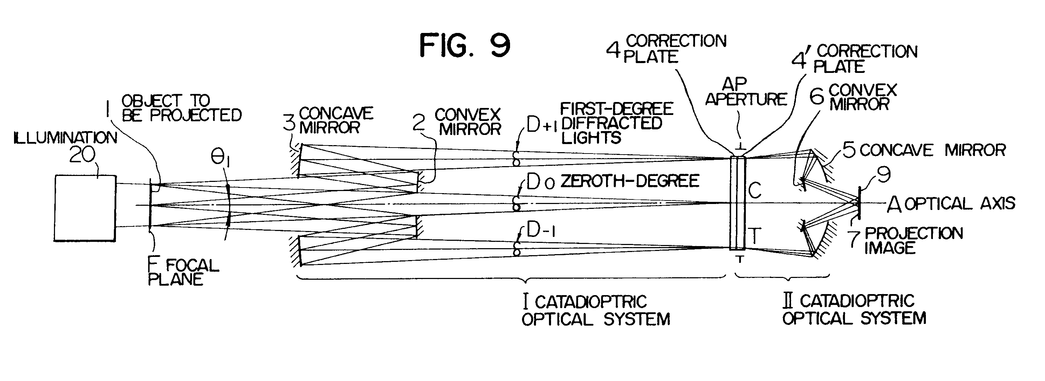

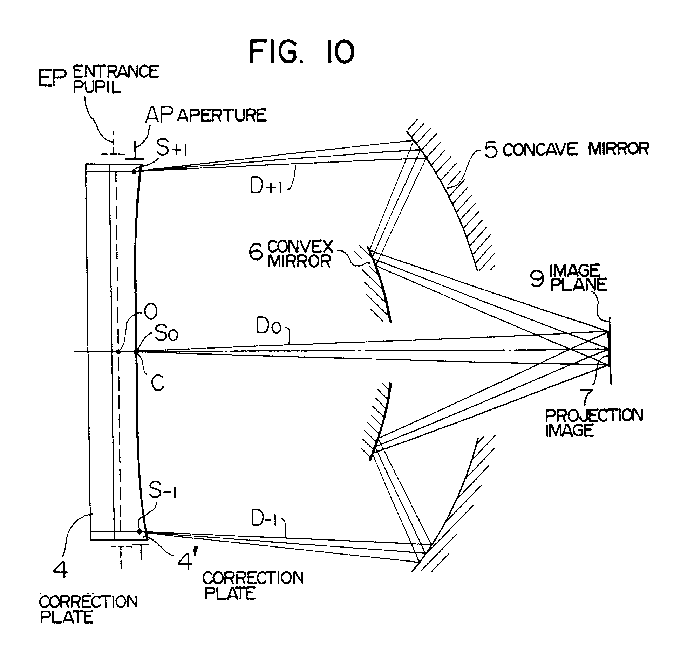

Fig. 9 is an overall cross sectional view showing a projection optical system for use in a precise copy according to the present invention. Fig. 10 is an enlarged diagram of the main part thereof.

The catadioptric optical system I on the object point side is constituted by a convex mirror 2 having an opening at the center, a concave mirror 3 having an opening at the center, and a refracting aspherical correction plate 4 whose one side is the flat surface. The object 1 to be projected is disposed on the focal plane F of the optical system I.

In the optical system I, the concave mirror 3, convex mirror 2, and correction plate 4 are arranged in accordance with this order for the object 1. The concave mirror 3 and convex mirror 2 are coaxially arranged with respect to the entrance pupil EP (which is given as an imaginary image of an aperture AP).

The catadioptric optical system II on the image point side is constituted by a refracting aspherical correction plate 4' whose one side is the flat surface, concave mirror 5 having an opening at the center, and convex mirror 6 having an opening at the center. In the optical system II, the correction plate 4', convex mirror 6, and concave mirror 5 are arranged in accordance with this order for the object 1. The convex mirror 6 and concave mirror 5 are coaxially arranged with regard to the aperture AP.

The optical systems I and II are rotationally symmetric around the reference axis and coupled so as to respectively face the correction plates 4 and 4' which are disposed on the coaxis at a slight distance away from each other.

The numerical aperture on the object point side is 0.076 and the numerical aperture on the image point side is 0.38 and the magnification is 1/5.

An illumination 20 emits coherent light and irradiates the whole object 1 so as to be converged and focused to the center of the entrance pupil EP after they passed through the catadioptric optical system I.

The zeroth-degree diffracted lights $D_0$, $\pm$ first-degree diffracted lights $D_{+1}$ and $D_{-1}$, and further the high-degree diffracted lights are generated from the object 1 which was illuminated by the coherent and convergent illumination 20. These diffracted lights enter the projecting lenses (I + II). The system is designed such that the incident angle which is determined by the numerical aperture (NA = $\sin\theta_0$) on the object point side of the projecting lenses (I + II) coincides with the angle $\theta_1$ of the first-degree diffracted light from the object 1. Therefore, none of the high-degree diffracted lights above the second-degree diffracted light enters the projecting lenses (I + II).

Among the diffracted lights from the object 1, the $\pm$ first-degree diffracted lights $D_{+1}$ and $D_{-1}$ pass through the opening of the concave mirror 3 and are reflected by the convex mirror 2 to the side of the object 1. Thereafter, the reflected lights are again reflected by the concave mirror 3 and pass through the correction plate 4 and enter the correction plate 4' which is disposed at a slight distance away from the correction plate 4. The light beams are converged and separated to the luminance point spectra $S_{+1}$ and $S_{-1}$ on the aperture AP. Then, the light beams are further reflected by the concave mirror 5 to the side of the object 1 and again reflected by the convex mirror 6 to the side opposite to the object 1 and pass through the opening of the concave mirror 5.

On the other hand, the zeroth-degree diffracted light beams $D_0$ progress through the opening of the concave mirror 3, opening of the convex mirror 2, and correction plates 4 and 4' so as to be converged to the center O of the entrance pupil EP. The light beams are focused to the center C on the aperture AP and become the luminance point spectrum $S_0$. Thereafter, the light beams pass through the opening of the convex mirror 6 and the opening of the concave mirror 5.

7

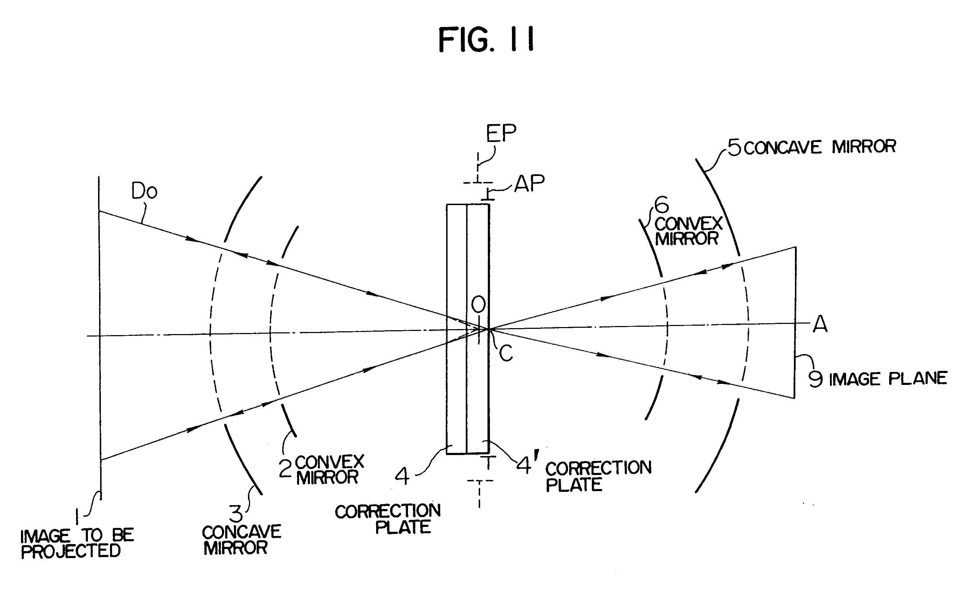

The zeroth-degree diffracted light beams $D_0$ are not reflected by the concave mirror 3, convex mirror 2, concave mirror 5, and convex mirror 6. As shown in Fig. 11, the concave mirror 5 and convex mirror 6 are coaxially arranged with respect to the focal point C (i.e., point C on the aperture AP) of the zeroth-degree diffracted lights $D_0$. The concave mirror 3 and convex mirror 2 are coaxially arranged with regard to the center O of the entrance pupil EP as an imaginary image of the aperture AP. Thus, the light beams are transmitted along the optical path similar to that in the case where they are reflected by the respective surfaces, so that no change occurs in the optical aberration.

The projection image is formed as interference fringes on an image plane 9 on which the zeroth-degree diffracted light beams $D_0$ and the ± first-degree diffracted light beams $D_{+1}$ and $D_{-1}$ having the same size are overlapped.

In the invention, only the fused quartz which is used to form the correction plates 4 and 4' is used as a refracting material. Therefore, the transmittance above 60% is derived even in the case of the wavelength in the range of the far ultraviolet rays of $\lambda = 200$ nm.

In the invention it is also possible to constitute the two correction plates 4 and 4' integrally coupled in their flat surface portions or previously integrally formed as a single plate, as shown in Fig.8, such that one single correction member 4a is commonly used by two catadioptric optical systems I and II.

According to the invention, two catadioptric optical systems consisting of the concave mirror members having openings, convex mirror members having openings, and refracting aspheric correction members are coupled so as to face on the coaxis around the correction members, thereby constituting one common catadioptric optical system. The object to be projected is convergently illuminated by coherent light. Therefore, when the reflecting optical system is used as a rediffracting optical system, the aperture loss, which ordinarily causes a problem, does not occur and the projection of a fine pattern can be performed. On the other hand, since the main refracting force is obtained by the reflecting system, only the refracting aspheric correction members are used as refracting materials. High transmittances can be obtained in the ranges of the ultraviolet rays and of the far ultraviolet rays and the system can be applied to the ranges of the ultraviolet rays and of the far ultraviolet rays. The high resolving power can be derived.

**Claims**

1. A projection optical system for use in making a precise copy, comprising:

a pair of catadioptric optical systems (I,II) each including an associated refracting aspheric correction member (4, 4'), a convex mirror member (2,6), and a concave mirror member (3,5) having an opening at the center thereof, said convex mirror member (2,6) and said concave mirror member (3,5) being coaxially arranged with a common curvature center located at the center of the entrance pupil (EP), and said associated refracting aspheric correction member being substantially placed at said entrance pupil,

said pair of catadioptric optical systems (I,II) being arranged rotationally symmetric around a reference axis and being coaxially coupled in such a way that said associated refracting aspheric correction members (4,4') face each other, one of said pair of catadioptric optical systems (I) being arranged on the side of the object to be projected, and the other catadioptric optical system (II) being arranged on the side of the projected image,

said object being placed on the focal plane (F) of said one of said pair of catadioptric optical systems (I) and said object being projected on the focal plane of said other of said pair of catadioptric optical systems (II);

**characterized in that**

said convex mirror members (2,6) each have an opening at the center thereof,

the optical system includes a coherent illuminating light source (20) for convergently illuminating the object to be projected such that a first part of the illumination rays from said light source (20) are focused by said one of said pair of catadioptric optical systems (I) to the plane of the entrance pupil (EP), and a second remaining part of the illumination rays from said light source (20) are converged through the opening of the convex mirror member (2) to the plane of the entrance pupil,

said one of said pair of catadioptric optical systems (I), located on the side of the object to be projected, is arranged in a manner such that after the rays emitted from the object pass through the opening of the concave mirror member (3) thereof, said second part of the rays pass through the opening of the convex mirror member (2) thereof and said first part of the rays are reflected by the convex mirror member (2) thereof to the concave mirror member (3) thereof and are further reflected by the concave mirror member (3) thereof, and both of said first and second parts of the rays pass through the refracting aspheric correction member (4) thereof, and

said other of said pair of catadioptric optical systems (II), located on the side of the projection image, is arranged in a manner such that after the incident rays passed through the refracting aspheric correction member (4') thereof, a first part of the rays pass through the opening of the convex mirror member (6) thereof and the opening of the concave mirror member (5) thereof and a second remaining part of the rays are reflected by the concave mirror member (5) thereof to the convex mirror member (6) thereof and are further reflected by the convex mirror member (6) thereof and pass through the opening of the concave mirror member (5) thereof, and all of the rays are overlapped in a plane which is perpendicular to the reference axis and behind the concave mirror member (5) thereof, so that an image is formed.

2. A projection optical system according to claim 1, wherein said pair of refracting correction aspheric members (4,4') facing each other are arranged with a slight distance between them.

3. A projection optical system according to claim 1, wherein the respective surfaces of said two refracting aspheric correction members that face each other are flat, and said two refracting aspheric correction members are integrally coupled in said respective flat surfaces.

## Patentansprüche

1. Optisches Projektionssystem zur Verwendung bei der Herstellung einer Präzisionskopie, umfassend:

Ein Paar katadioptrischer optischer Systeme (I,II), die jeweils ein zugehöriges asphärisches Refraktionsberichtigungselement (4,4'), ein konvexes Spiegelelement (2,6) und ein konkaves Spiegelelement (3,5) mit einer Öffnung in der Mitte einschließen, wobei das konvexe Spiegelelement (2,6) und das konkave Spiegelelement (3,5) koaxial mit einer gemeinsamen Krümmungsmitte angeordnet sind, die in der Mitte der Eingangslinse (EP) liegt, und wobei das zugehörige asphärische Rerraktionsberichtigungselement im wesentlichen an der Eingangslinse angeordnet ist,

wobei das Paar katadioptrischer optischer Systeme (I,II) rotationssymmetrisch um eine Bezugsachse angeordnet ist und koaxial derart gekoppelt ist, daß die zugehörigen asphärischen Refraktionsberichtigungselemente (4,4') einander gegenüberliegen, wobei eines des Paares katadioptrischer optischer Systeme (I) auf der Seite des zu projizierenden Objekts liegt und das andere katadioptrische optische System (II) auf der Seite des projizierten Bildes liegt,

wobei das Objekt in der Brennebene (F) des einen des Paares katadioptrischer optischer Systeme (I) angeordnet ist und das Objekt auf die Brennebene des anderen des Paares katadioptrischer optischer Systeme (II) projiziert wird;

dadurch gekennzeichnet, daß

die konvexen Spiegelelemente (2,6) jeweils eine Öffnung in der Mitte aufweisen,

das optische System eine kohärent leuchtende Lichtquelle (20) zum derartigen konvergenten Beleuchten des zu projizierenden Objekts einschließt, daß ein erster Teil der Beleuchtungsstrahlen von der Lichtquelle (20) von dem ersten des Paares katadioptrischer optischer Systeme (I) auf die Ebene der Eingangslinse (EP) fokussiert wird und ein verbleibender zweiter Teil der Beleuchtungsstrahlen der Lichtquelle (20) durch die Öffnung des konvexen Spiegelelementes (2) auf die Ebene der Eingangslinse konvergiert wird,

wobei das eine auf der Seite des zu projizierenden Objektes angeordnete des Paares katadioptrischer optischer Systeme (I) derart ausgelegt ist, daß, nachdem die von dem Objekt emittierten Strahlen die Öffnung des zugehörigen konkaven Spiegelelements (3) passiert haben, der zweite Teil der Strahlen durch die Öffnung des zugehörigen konvexen Spiegelelements (2) hindurchtritt und der erste Teil der Strahlen von dem zugehörigen konvexen Spiegelelement auf das zugehörige konkave Spiegelelement (3) reflektiert und ferner von dem zugehörigen konkaven Spiegelelement (3) reflektiert wird und sowohl der erste als auch der zweite Teil der Strahlen durch das zugehörige asphärische Refraktionsberichtigungselement (4) hindurchtritt, und

das auf der Seite des projizierten Bildes gelegene andere des Paares katadioptrischer optischer Systeme (2) derart ausgelegt ist, daß, nachdem die einfallenden Strahlen durch das zugehörige asphärische Refraktionsberichtigungselement (4') hindurchgetreten sind, ein erster Teil der Strahlen durch die Öffnung des zugehörigen konvexen Spiegelelements (6) und die Öffnung des zugehörigen konkaven Spiegelelements (5) hindurchtritt und ein verbleibender zweiter Teil der Strahlen von dem zugehörigen konkaven Spiegelelement (5) auf das zugehörige konvexe Spiegelelement (6) reflektiert wird und ferner von dem zugehörigen konvexen Spiegelelement (6) reflektiert wird und durch die Öffnung des zugehörigen konkaven Spiegelelement (5) hindurchtritt, und sich alle Strahlen in einer Ebene überlagern, die senkrecht auf der Bezugsachse steht und hinter dem zugehörigen konkaven Spiegelelement (5) liegt, so daß ein Bild erzeugt wird.

**2.** Optisches Projektionssystem nach Anspruch 1, bei dem das Paar einander gegenüberliegender asphärischer Refraktionsberichtigungselemente (4,4') mit geringem gegenseitigem Abstand angeordnet ist.

**3.** Optisches Projektionssystem nach Anspruch 1, bei dem die jeweils einander gegenüberliegenden Oberflächen der beiden asphärische Refraktionsberichtigungselemente eben sind und die beiden asphärischen Refraktionsberichtigungselemente an den entsprechenden ebenen Oberflächen integral gekoppelt sind.

**Revendications**

**1.** Système optique de projection utilisable dans l'exécution de copies de précision, comprenant:

une paire de systèmes optiques catadioptriques (I, II) contenant chacun un élément de correction asphérique réfringent associé (4, 4'), un élément miroir convexe (2, 6) et un élément miroir concave (3, 5) présentant une ouverture en son centre, ledit élément miroir convexe (2, 6) et ledit élément miroir concave (3, 5) étant disposés coaxialement, avec un centre commun de courbure situé au centre de la pupille d'entrée (EP), et ledit élément de correction asphérique réfringent assosié étant placé pratiquement au niveau de ladite pupille d'entrée,

les deux systèmes optiques catadioptriques (I, II) étant disposés de manière à présenter une symétrie de révolution autour d'un axe de référence et étant accouplés coaxialement de sorte que lesdits éléments de correction asphériques refringents associés (4, 4') soient face à face, l'un (I) des deux systèmes optiques catadioptriques étant disposé du côté de l'objet à projeter et l'autre système optique catadioptrique (II) étant disposé du côté de l'image projetée,

ledit objet étant placé dans le plan focal du premier (I) des deux systèmes optiques catadioptriques et étant projeté sur le plan focal de l'autre (II) des deux systèmes optiques catadioptriques;

caractérisé en ce que

lesdits éléments miroirs convexes (2, 6) présentent chacun une ouverture en leur centre,

le système optique contient une source de lumière cohérente (20) pour l'éclairage convergent de l'objet à projeter, une première partie des rayons d'éclairage issus de ladite source de lumière (20) étant focalisée par le premier (I) des deux systèmes optiques catadioptriques sur le plan de la pupille d'entrée (EP), et la seconde partie ou partie restante des rayons d'éclairage issus de ladite source de lumière (20) convergeant, à travers l'ouverture de l'élément miroir convexe (2), vers le plan de la pupille d'entrée,

le premier (I) des deux systèmes optiques catadioptriques, situé du côté de l'objet à projeter, est agencé de telle manière qu'après que les rayons émis par l'objet ont traverse l'ouverture de son élément miroir concave (3), ladite seconde partie des rayons passe à travers l'ouverture de son élément miroir convexe (2) et ladite première partie des rayons soit réfléchie par son élément miroir convexe (2) vers son élément miroir concave (3) et soit réfléchie de nouveau par son élément miroir concave (3), et que lesdites première et seconde parties des rayons passent l'une et l'autre à travers son élément de correction asphérique réfringent, et

le second (II) des deux systèmes optiques catadioptriques, situé du côté de l'image projetée, est agencé de telle manière qu'après que les rayons incidents ont traversé son élément de correction asphérique réfringent (4'), une première partie des rayons passe à travers l'ouverture de son élément miroir convexe (6) et à travers l'ouverture de son élément miroir concave (5), et une seconde partie ou partie restante des rayons soit réfléchie par son élément miroir concave (5) vers son élément miroir convexe (6), soit réfléchie de nouveau par son élément miroir convexe (6) et passe à travers l'ouverture de son élément miroir concave (5), et que tous les rayons se recouvrent dans un plan qui est perpendiculaire à l'axe de référence et situé en arrière de l'élément miroir concave (5) de ce système, ce qui fait qu'une image est formée.

**2.** Système optique de projection selon la revendication 1, dans lequel les deux éléments asphériques de correction réfringents (4, 4') disposés face à face sont espacés l'un de l'autre d'une faible distance.

**3.** Système optique de projection selon la revendication 1, dans lequel les surfaces des deux éléments de correction asphériques refringents qui sont disposés face à face sont plates, et ces deux éléments de correction asphériques refringents sont accouplés d'un seul tenant par lesdites surfaces plates respectives.

# FIG. 1

C G G G G G C C

OPTICAL GLASS

# FIG. 2

I

P

101 100

O

# FIG. 3

# FIG. 4

FIG. 5

F FOCAL PLANE

3 CONCAVE MIRROR

2 CONVEX MIRROR

4 CORRECTION PLATE

4' CORRECTION PLATE

6 CONVEX MIRROR

5 CONCAVE MIRROR

C

L    R

A OPTICAL AXIS

7 PROJECTION IMAGE

I OBJECT TO BE PROJECTED

I CATADIOPTRIC OPTICAL SYSTEM

E ENTRNCE PUPIL

II CATADIOPTRIC OPTICAL SYSTEM

FIG. 6

3 CONCAVE MIRROR

2 CONVEX MIRROR

4 CORRECTION PLATE

4' CORRECTION PLATE

6 CONVEX MIRROR

5 CONCAVE MIRROR

IMAGE HEIGHT

I OBJECT TO BE PROJECTED

OBJECT HEIGHT $h_1$

$r_2$

$r_1$

$\theta_1$

$r_3$    $r_7$    $r_5$

$r_4$    $r_6$

$r_8$

$d_7$

$\theta_2$    $h_2$

A OPTICAL AXIS

$d_1$

$d_2$

$d_3$    $d_6$

$d_4$    $d_5$

$r_7$

7 PROJECTION IMAGE

$n_1$    $n_2$

FOCAL DISTANCE $f_1$

FOCAL DISTANCE $f_2$

I CATADIOPTRIC OPTICAL SYSTEM

E ENTRANCE PUPIL

II CATADIOPTRIC OPTICAL SYSTEM

EP 0 237 041 B1

EP 0 237 041 B1

## FIG. 7

F 1.3

-0.001    0    0.001

SPHERICAL ABERRATION

y'
20

S —M

-0.1    0    0.1

ASTIGMATISM

y'
20

-0.1%    0.1 %

DISTORTION ABERRATION

## FIG. 8

4a   CORRECTION PLATE

FIG. 9

I CATADIOPTRIC OPTICAL SYSTEM

II CATADIOPTRIC OPTICAL SYSTEM

EP 0 237 041 B1

# FIG. 10

EP ENTRANCE PUPIL

AP APERTURE

S+1

D+1

5 CONCAVE MIRROR

6 CONVEX MIRROR

9 IMAGE PLANE

O
So
Do
C

7 PROJECTION IMAGE

S-1

D-1

4'

CORRECTION PLATE

4

CORRECTION PLATE

# FIG. 11

EP 0 237 041 B1